# EUROPEAN PATENT APPLICATION

(11) **EP 3 923 366 A1**
(43) Date of publication of application: **15.12.2021**
(21) Application number: 20752146.9
(22) Date of filing: 15.01.2020
(51) Int. Cl.: H01M 2/02, H01M 2/04, H01M 2/08, H01M 2/10, F16J 15/10, H05K 5/06

(54) **SEAL STRUCTURE**

(30) Priority: 04.02.2019 JP 2019018236
(71) Applicant: NOK Corporation, Tokyo 105-8585 (JP)
(72) Inventor: ONO, Tasuku, Aso-shi, Kumamoto 869-2231 (JP)
(74) Representative: Global IP Europe Patentanwaltskanzlei
(86) International application number: PCT/JP2020/001050
(87) International publication number: WO 2020/162123

(57) **Abstract**

A sealing structure which can more simply and securely hold a gasket on an upper end of a side wall of a battery case as attached member is provided. A sealing structure 100 includes a gasket 110 and an attachment wall 120. The gasket 110 has a shape of straddling an upper end 11a of a side wall 11 of a battery case 10. The gasket on the top surface side is configured to be in tight contact with a cover 20 for covering an opening side of the battery case 10. The attachment wall 120 is fastened to the side wall 11 of the battery case 10, and has a placement surface 120a arranged to be in contact with a lower end 21a of an engagement portion 21 arranged on an outer edge of the cover 20 and an lower end of the gasket 110.

## Description

### FIELD

The present disclosure relates to a sealing structure.

### BACKGROUND

With the development of e-Mobility, battery case gaskets which seal against leakage from a gap between a battery case for accommodating a battery for vehicles (e.g., electric car) and a cover for covering the battery case are under development. The battery case gaskets have a long peripheral length and a large plan view shape corresponding to a size of such a battery case. For this reason, because it is difficult to form such a long battery case gasket by press forming, the battery case gasket is necessarily formed by extrusion.

Extruded parts which are formed by extrusion have a fixed shape along their peripheral length. Accordingly, in order to attach such a gasket, the extruded part is necessarily subjected to additional processing, or a groove or the like for holding the gasket is additionally formed on a member to which the gasket is attached. An example of the related art of gasket attachment is provided by Japanese Patent Laid-Open Publication No. 2012-122536 which discloses a gasket of extruded part having through holes for bolt insertion. Another example is provided by Japanese Patent Laid-Open Publication No. 2017-172756 which discloses a sealing structure having a circular groove formed on a member to which the gasket is attached.

### BRIEF SUMMARY

### TECHNICAL PROBLEM

Additional processing in which through holes or the like are formed on the extruded part as gasket is laborious and increases its cost. On the other hand, in the case in which the member to which the gasket is attached is formed by press forming, a space on which a gasket attachment groove is formed cannot be sufficiently provided, or the member to which the gasket is attached is necessarily additionally subjected to additional processing in which a groove or the like is formed. For these reasons, a sealing structure is required to more simply and securely hold a gasket on an attached member such as battery case.

An object of the present disclosure is to provide a sealing structure which can more simply and securely hold a gasket on an attached member.

### SOLUTION TO PROBLEM

A sealing structure according to the present disclosure includes
a gasket having a shape of straddling an upper end of a side wall of a battery case, the gasket on a top surface side configured to be in tight contact with a cover for covering an opening side of the battery case; and
an attachment wall configured to be fastened to the side wall of the battery case, and the attachment wall having a placement surface arranged to be in contact with a lower end of an engagement portion arranged on an outer edge of the cover and an lower end of the gasket.

### ADVANTAGEOUS EFFECTS

According to a sealing structure of the present disclosure, a gasket can be more simply and securely held on an attached member.

### BRIEF DESCRIPTION OF DRAWINGS

Fig. 1 is a plan view entirely showing the construction of a sealing structure according to an embodiment.
Fig. 2 is a perspective view showing the construction of a principal part of the sealing structure according to the embodiment.
Fig. 3 is a cross-sectional view showing the construction of a principal part of the sealing structure according to the embodiment.

### DETAILED DESCRIPTION

The following description will describe a sealing structure according to a preferred embodiment. It is noted that the scope of the present disclosure defined by claims attached hereto is not limited to the embodiment. Not all the components described in the description of the embodiment are essential components for the solution means of the present disclosure.

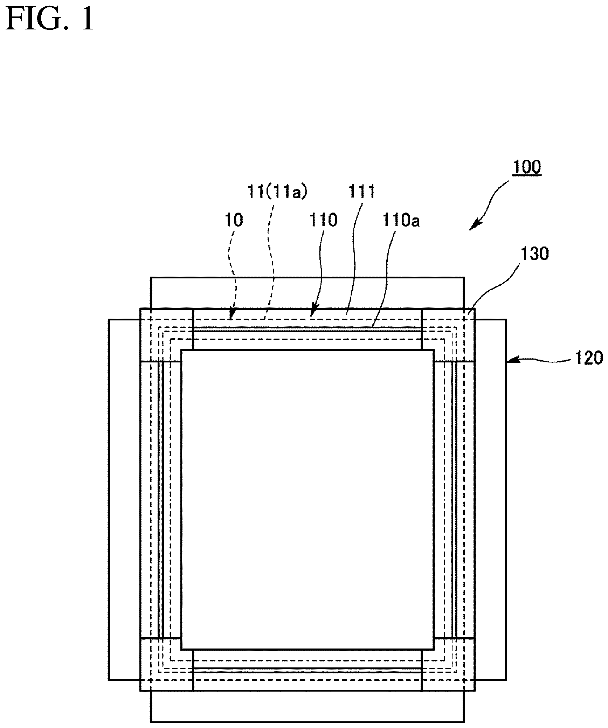

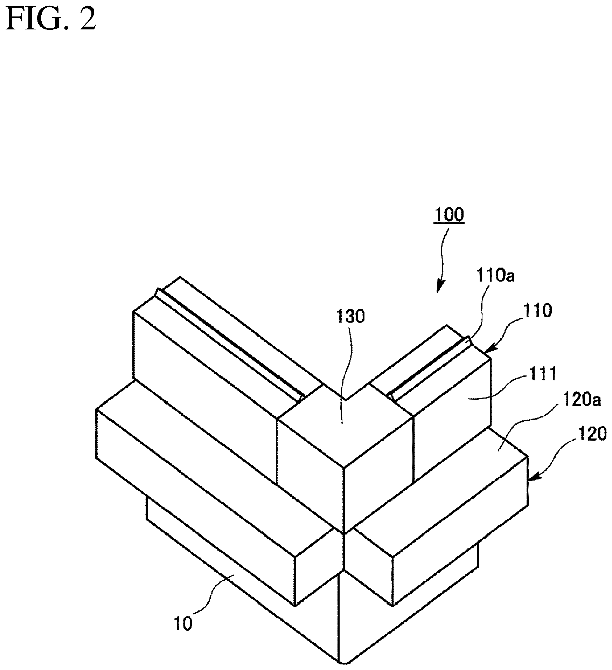

The schematic construction of a sealing structure according to an embodiment is first schematically described with reference to Figs. 1 and 2. Fig. 1 is a plan view showing the sealing structure according to this embodiment which is attached to the battery case. Fig. 2 is a perspective view showing a part of the sealing structure according to this embodiment including a coupling portion.

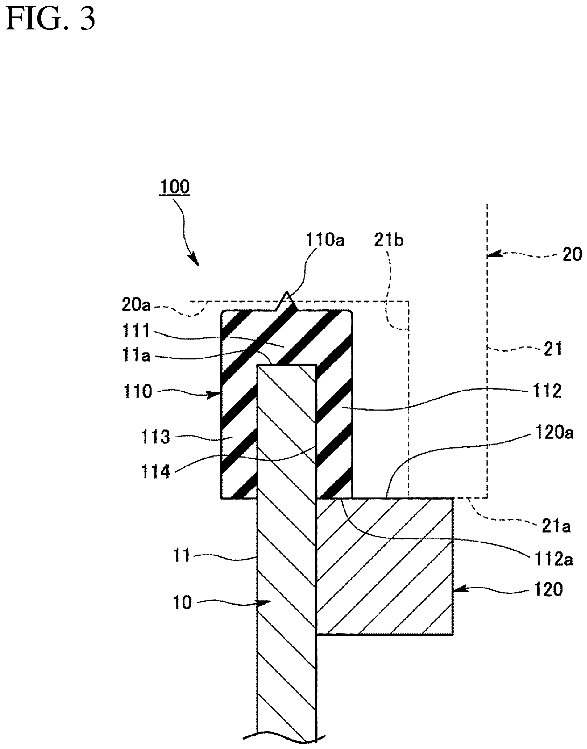

The sealing structure 100 is a gasket for a battery case which seals leakage from a gap between a battery case 10 and a covers 20 which covers the battery case 10 (see Fig. 3), for example. The battery case 10 accommodates a vehicle battery which is mainly used for vehicles such as electric car, fuel-cell car, and hybrid car. The sealing structure 100 according to this embodiment is arranged on an opening side of the battery case 10 as shown in Fig. 1. The sealing structure 100 includes a gasket 110, welded walls 120, and coupling portions 130.

The gasket 110 is held on the battery case 10. The gasket 110 provides hermeticity between the battery case 10 and the cover 20 (see Fig. 3). The gasket 110 is an extruded part which is formed of a rubber-like elastic material having a rubber hardness degree not higher than 70 by extrusion. Exemplary rubber-like elastic materials can be provided by a rubber material, a synthetic resin material having rubber-like elasticity, and the like.

The gasket 110 according to this embodiment includes gasket main bodies 111 which extend along their corresponding edge of the battery case 10 on the opening side as shown in Fig. 1. The gasket main bodies 111 have a liner elongated shape, and a fixed sectional shape along their entire length. The ends of the gasket main bodies 111 are fitted into the coupling portions 130 so that the gasket main bodies 111 are coupled to each other by the coupling portions 130. The coupling portions 130 are formed of rubber or the like. Accordingly, the gasket 110 has a rectangular frame shape.

The gasket 110 according to this embodiment has a shape straddling an upper end 11a of a side wall 11 of the battery case 10 as shown in Figs. 1 and 2. The gasket 110 is held on the upper end 11a of the side wall 11 without any adhesive. In addition, the gasket 110 according to this embodiment includes sealing projections 110a. The sealing projections 110a will be brought in tight contact with the cover 20 which covers the opening side of the battery case 10 (see Fig. 3). The sealing projection 110a extends along the center line on a top surface of the gasket main body 111. The construction of the gasket 110 according to this embodiment will be discussed in more detail later.

The welded walls 120 are a bar-shaped member which is formed of metal such as steel and has a rectangular cross-sectional shape. The welded walls 120 are fastened onto the side walls 11 of the battery case 10 on their exterior sides. The welded walls 120 serve as an attachment wall which adjusts an interference of the cover 20 with the gasket 110 and positioning of the cover 20. When the battery case 10 is covered by the cover 20, the welded walls 120 according to this embodiment are attached so that a placement surface 120a contacts an lower end 21a of an engagement portion 21 which is arranged on the outer edge of the cover 20 (see Fig. 3) and an lower end 112a of the gasket main body 111 (see Fig. 3) to adjust an interference of the cover 20 with the gasket 110 and positioning of the cover 20. The welded walls 120 according to this embodiment are fastened onto the side wall 11 of the battery case 10 by welding from the exterior side.

The construction of a principal part of the sealing structure according to this embodiment is now described with reference to Fig. 3. Fig. 3 is a cross-sectional view illustrating a positional relationship between the gasket and the welded wall of the sealing structure according to this embodiment which are attached to the battery case, and the cover taken along a line perpendicular to a length direction of the gasket main body.

The sealing structure 100 according to this embodiment surely provides hermeticity mainly in the vertical direction between the battery case 10 and the cover 20. The gasket 110 has a shape straddling an upper end 11a of a side wall 11 of the battery case 10 which is an attached member as shown in Fig. 3. Also, the metal welded walls 120 are fastened onto parts of the side walls 11 of the battery case 10 in proximity to their upper ends 11a by welding from the exterior side. In other words, the gasket 110 has a shape which covers the upper end 11a of the side wall 11 from the interior side to the exterior side.

The gasket 110 according to this embodiment includes the gasket main bodies 111 and engagement grooves 114 as shown in Fig. 3. The gasket main body 111 includes the sealing projection 110a on the top surface of the gasket main body 111 which will be brought in tight contact with the cover 20. The engagement groove 114 is formed on a bottom surface side of the gasket main body 111, and engages the upper end 11a of the side wall 11. That is, the gasket 110 according to this embodiment includes extruded parts as the gasket main bodies 111 which have the engagement groove 114 on the inner surface side and are formed by extrusion. According to this arrangement, the gasket can be easily held on the upper ends 11a of the side walls 11 without any adhesive.

The sealing projection 110a is formed on the top surface of the gasket main body 111. Hermeticity between the battery case 10 and a ceiling surface 20a of the cover 20 can be surely provided by elastic deformation of the sealing projection 110a. The engagement groove 114 is formed on the bottom surface side of the gasket main body 111. An exterior-side protruding portion 112 and an interior-side protruding portion 113 are arranged on the both side edges of the engagement groove 114. The exterior-side protruding portion 112 protrudes downward from one end of the gasket main body 111 to engage with the exterior side of the side wall 11. The interior-side protruding portion 113 protrudes downward from another end of the gasket main body 111 to engage with the interior side of the side wall 11. Accordingly, since the engagement groove 114 is formed on the bottom surface side of the gasket main body 111, the gasket 110 according to the embodiment covers the upper end 11a of the side wall 11 from the interior side to the exterior side.

Also, in the gasket 110 according to this embodiment, the lower end 112a of the exterior-side protruding portion 112 contacts the placement surface 120a of the welded wall 120. Accordingly, when the battery case 10 is covered by the cover 20 so that the sealing projections 110a are deformed, the welded walls 120 engage the lower ends 112a of the exterior-side protruding portions 112. According to this arrangement, an excess amount of deformation of the sealing projection 110a can be prevented. As a result, reduction of sealing performance can be prevented. As discussed above, the welded walls 120 according to the embodiment are fastened onto the side walls 11 of the battery case 10 by welding. According to this arrangement, the interference of the cover 20 with the sealing projection 110a can be adjusted to a desired amount.

Also, when the battery case 10 is covered by the cover 20, the welded walls 120 according to this embodiment are attached so that the placement surface 120a will contact the lower end 21a of the engagement portion 21 on the outer edge side of the cover 20. That is, the welded walls 120 easily position the cover 20, and additionally prevent reduction of the sealing performance caused by an excess load of the weight of the cover 20 applied to the sealing projections 110a of the gasket 110.

In order that the sealing projections 110a of the gasket 110 can surely provide hermeticity, the interference of the cover 20 with the sealing projection 110a is preferably adjusted not greater than the height of the sealing projection 110a. For this reason, in this embodiment, the gasket 110 of extruded part is dimensioned so that the height from the lower end 112a of the exterior protruding portion 112 of the gasket 110 to the top surface of the gasket main body 111 substantially agrees with the height of the engagement portion 21 of the cover 20.

Although the gasket main body 111 of the sealing structure 100 has been described to include the sealing projection 110a which is arranged on the top surface of the gasket main body 111 to be in tight contact with the ceiling surface 20a of the cover 20 in this embodiment, the gasket 110 can have other forms as long as the sealing performance of the gasket 110 is surely achieved. For example, a member which achieves sealing performance (e.g., elastically deformable sealing portion or seal lip) can be arranged in a part which will be brought in tight contact with the ceiling surface 20a of the cover 20 of the gasket main body 111. In this case, a space is preferably defined between the exterior-side protruding portion 112 and the inner peripheral surface 21b of the engagement portion 21 of the cover 20 so that the exterior-side protruding portion 112 of the gasket main body 111 can be elastically deformed.

Although the attachment walls of the sealing structure 100 according to this embodiment have been described to include the welded wall 120 which is fastened by welding, means for fastening the attachment wall onto the side wall 11 of the battery case 10 is not limited to welding. For example, in the case in which both the battery case and the attachment wall are formed of a rigid resin or the like, the attachment wall may be fastened onto the battery case by other fastening means such as adhesive or thermocompression bonding.

As discussed above, in the sealing structure 100 according to this embodiment, the gasket 110 has a shape directly straddling the side wall 11 of the battery case 10 to be held so that the engagement groove 114 of the gasket 110 engages with the side wall 11 of the battery case 10 as sheet metal to which the gasket 110 is attached (attached member). Also, the welded wall 120 is fastened as the attachment wall by welding from the exterior side of the side wall 11 of the battery case 10 to adjust an interference of the cover 20 with the gasket 110 and positioning of the cover 20. For this reason, the gasket 110 can be securely held on the side walls 11 of the battery case 10 as attached member by a simple structure without additional processing in which fastening through holes, protrusions or the like are formed on the gasket 110 of extruded part formed by extrusion.

Also, according to the sealing structure 100 of this embodiment, the gasket 110 can be held in place and provide sealing effects without forming grooves or the like for holding the gasket 110 on the side walls 11 of the battery case 10 by presswork. For this reason, according to the sealing structure 100 of this embodiment, the gasket 110 of extruded part which is formed by extrusion is not necessarily subjected to additional processing, and grooves or the like for holding the gasket 110 are not required to be formed on the side walls 11 of the battery case 10 as the attached member to which the gasket is attached.

In addition, sealing performance between the battery case 10 and the cover 20 in the vertical direction can be surely achieved by a simple structure and simple method. As a result, in the case in which the sealing structure 100 according to this embodiment is applied to gaskets for battery cases to be used for vehicles such as electric cars, the workability and attachment performance of a gasket for battery cases can be improved. Therefore, the sealing structure 100 according to this embodiment has great value in industry.

Although the sealing structure of one embodiment has been described above in detail, it will be easily understood by a person skilled in the art that various changes can be made. For example, a term that is stated together with a different term used in a broader sense of the term or synonymous with the term at least once in the specification or the drawings can be replaced by the different term in other statements in the specification or the drawings. Also, the construction and operation of the sealing structure are not limited to the embodiment but various changes can be made.

### Reference Signs List

- 10 ...: Battery Case
- 11 ...: Side Wall
- 11a ...: Side Wall Upper End
- 20 ...: Cover
- 20a ...: Ceiling Surface
- 21 ...: Engagement Portion
- 21a ...: Engagement Portion Lower End
- 21b ...: Engagement Portion Inner Peripheral Surface
- 100 ...: Sealing Structure
- 110 ...: Gasket
- 110a ...: Sealing Projection
- 111 ...: Gasket Main Body
- 112 ...: Exterior-Side Protruding Portion
- 112a ...: Exterior-Side Protruding Portion Lower End
- 113 ...: Interior-Side Protruding Portion
- 114 ...: Engagement Groove
- 120 ...: Welded Wall (Attachment Wall)
- 120a ...: Welded Wall Placement Surface
- 130 ...: Coupling Portion

## Claims

1. A sealing structure comprising:
a gasket having a shape of straddling an upper end of a side wall of a battery case, the gasket on a top surface side configured to be in tight contact with a cover for covering an opening side of the battery case; and
an attachment wall configured to be fastened to the side wall of the battery case, and the attachment wall having a placement surface arranged to be in contact with a lower end of an engagement portion arranged on an outer edge of the cover and an lower end of the gasket.

2. The sealing structure according to claim 1, wherein
the gasket includes
a gasket main body including a sealing projection arranged on a top surface of the gasket main body to be in tight contact with the cover, and
an engagement groove formed in a bottom surface side of the gasket main body to be in engagement with the upper end of the side wall of the battery case.

3. The sealing structure according to claim 1 or 2, wherein
the gasket includes
an exterior-side protruding portion protruding from an exterior side of the gasket main body, and
an interior-side protruding portion protruding from an interior side of the gasket main body.

4. The sealing structure according to claim 3, wherein the exterior protruding portion is in contact with the placement surface.

5. The sealing structure according to any one of claims 1 to 4, wherein the attachment wall is a welded wall configured to be fastened onto the side wall of the battery case by welding.

6. The sealing structure according to any one of claims 1 to 5, wherein the gasket is an extruded part formed of a rubber-like elastic material having a rubber hardness degree not higher than 70.

7. The sealing structure according to any one of claims 2 to 6, wherein
the gasket includes a plurality of the gasket main bodies, and
the sealing structure further includes coupling portions that couple the plurality of gasket main bodies to each other.

8. The sealing structure according to any one of claims 2 to 7, wherein the gasket main body has a linear shape.
